Europäisches Patentamt

European Patent Office

Office européen des brevets

(19)

(11) Numéro de publication : **0 470 898 A1**

## (12) DEMANDE DE BREVET EUROPEEN

(21) Numéro de dépôt : 91402170.4

(22) Date de dépôt : 02.08.91

(51) Int. Cl.⁵ : **C04B 38/00, C04B 35/46, C04B 35/48, H01L 41/187**

(30) Priorité : 07.08.90 FR 9010065

(43) Date de publication de la demande :
**12.02.92 Bulletin 92/07**

(84) Etats contractants désignés :
**DE GB SE**

(71) Demandeur : **THOMSON-CSF**
**51, Esplanade du Général de Gaulle**
**F-92800 Puteaux (FR)**

(72) Inventeur : **Gaucher, Philippe**
**THOMSON-CSF, SCPI, Cedex 67**
**F-92045 Paris la Défense (FR)**
Inventeur : **Ganne, Jean-Pierre**
**THOMSON-CSF, SCPI, Cedex 67**
**F-92045 Paris la Défense (FR)**
Inventeur : **Dubois, Jean-Claude**
**THOMSON-CSF, SCPI, Cedex 67**
**F-92045 Paris la Défense (FR)**

(74) Mandataire : **Guérin, Michel et al**
**THOMSON-CSF SCPI**
**F-92045 PARIS LA DEFENSE CEDEX 67 (FR)**

(54) **Céramique piézoélectrique à porosité contrôlée.**

(57)   L'invention concerne un procédé de fabrication d'un matériau céramique à porosité contrôlée, utilisant la synthèse d'un aérogel obtenu par séchage hypercritique d'un gel à forte porosité.
Application dans le domaine de l'acoustique sous-marine (sonars actifs et passifs).

FIG.3

La présente invention concerne la réalisation de céramique piézoélectrique à porosité contrôlée présentant des propriétés intéressantes dans le domaine de l'acoustique sous marine (sonars actifs et passifs), de la détection médicale (échographie) et du traitement du signal (filtres, lignes à retard....).

De manière générale, les matériaux ferroélectriques polarisés par une tension appliquée préalablement à leur utilisation possèdent des coefficients de charge piézoélectrique élevés traduisant la création de charge en réponse à une pression.

Ces matériaux ferroélectriques peuvent être de type céramique tels que le titanate de baryum ou le titano-zirconate de plomb (PZT) ou bien de type polymère comme le polyfluorure de vinylidène (PVDF).

Les différentes caractéristiques physiques illustrant les performances de ces matériaux, dans les applications citées précédemment, sont :

– le coefficient de charge hydrostatique $d_h$ défini comme la combinaison des coefficients $d_{33}$ et $d_{31}$ caractérisant l'efficacité des modes respectivement transverse et longitudinal : $d_h = d_{33} - 2d_{31}$

– le coefficient de couplage $K_h$, traduisant l'efficacité du matériau piézoélectrique dans la conversion du signal électrique en ultrasons et inversement :

$$k_h = d_h 2 / \varepsilon . S$$

où

$\varepsilon$ constante diélectrique

S compliance élastique

– le coefficient de tension $g_h$ (dans le mode de fonctionnement passif : détection d'ondes sonores) :

$$g_h = dE/dP = d_h / \varepsilon$$

où E champ électrique induit par la pression P.

Les matériaux céramiques à faible compliance car très rigides présentent des coefficients de couplage $K_h$ plus intéressants que les polymères tels que le PVDF, néanmoins leur constante diélectrique très élevée (de l'ordre de 1700 pour le PZT) et leur forte densité nuisent à l'adaptation de l'impédance acoustique avec celle de l'eau ainsi qu'au facteur de mérite $g_h$.

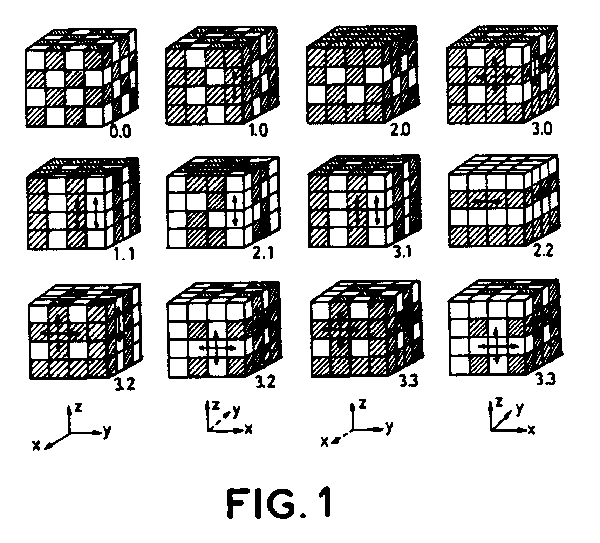

Des travaux ont donc été menés pour améliorer les performances des matériaux céramiques, plus précisément pour en diminuer la constante diélectrique et en augmenter les différents coefficients $d_h$, $K_h$ et $g_h$. Les céramiques telles que le PZT sont des matériaux très denses que l'on peut alléger en réalisant des matériaux composites à deux phases : une phase 1 céramique et une phase 2, résine ou air. Il existe plusieurs structures possibles dans lesquelles les phases 1 et 2 sont différemment connectées (figure 1). Lorsqu'une poudre, phase 1, (grains non interconnectés) est dispersée dans un matériau élastique, phase 2, interconnecté dans les trois directions, il s'agit d'un composite 0-3.

Dans ce type de structure la permittivité se trouve abaissée mais au détriment du coefficient $K_h$ puisque la compliance S est augmentée.

Une connectivité (1, 3) obtenue en disposant des barres de PZT perpendiculairement aux électrodes, permet un meilleur transfert des contraintes et des polarisations dans la céramique, que celui obtenu avec une connectivité (0,3).

Une connection complète au niveau de la céramique améliore encore d'avantage les performances. Cette connection peut être réalisée par la méthode dite de la cire perdue utilisant un matériau extrêmement poreux : le corail. Par ce procédé le matériau PZT est bien interconnecté dans les trois directions de l'espace et les interstices sont remplis avec de la résine. On obtient environ 50 % du volume occupé par la céramique. Les performances de ces différents types de matériaux composites sont donnés dans le tableau ci-dessous.

|  | PZT pur | Composition (0,3) PZT chloroprène | Composition (1,3) PZT - epoxy | Composition (3,3) réplique corail |
|---|---|---|---|---|
| $\varepsilon_{33}$ | 1 700 | 31 | 500 | 400 |
| $d_h$ ($10^{-12}$ C/N) | 50 | 34 | 20 | 100 |
| $g_h$ ($10^{-3}$ V.m/N) | 3 | 1 080 | 40 | 250 |
| $d_n \cdot g_h$ ($10^{-15}$ m/N) | 150 | 36 | 800 | 25 000 |

Le facteur de mérite $d_h.g_h$ est une caractéristique prépondérante pour un matériau piézoélectrique puisqu'il traduit les performances globales en émission et en réception (bon rendement en émission et bonne sensibilité en réception).

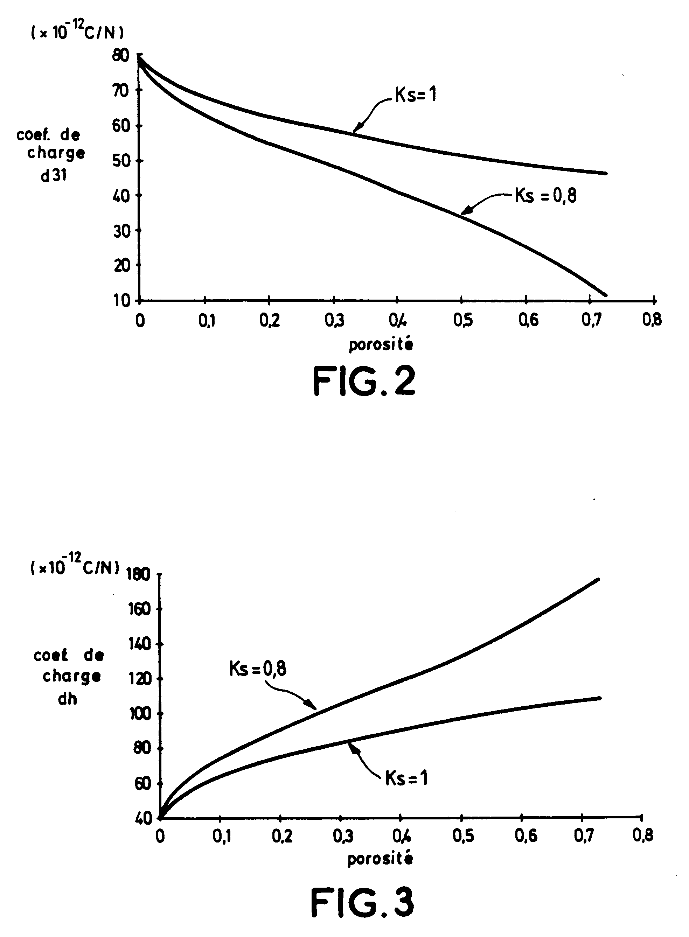

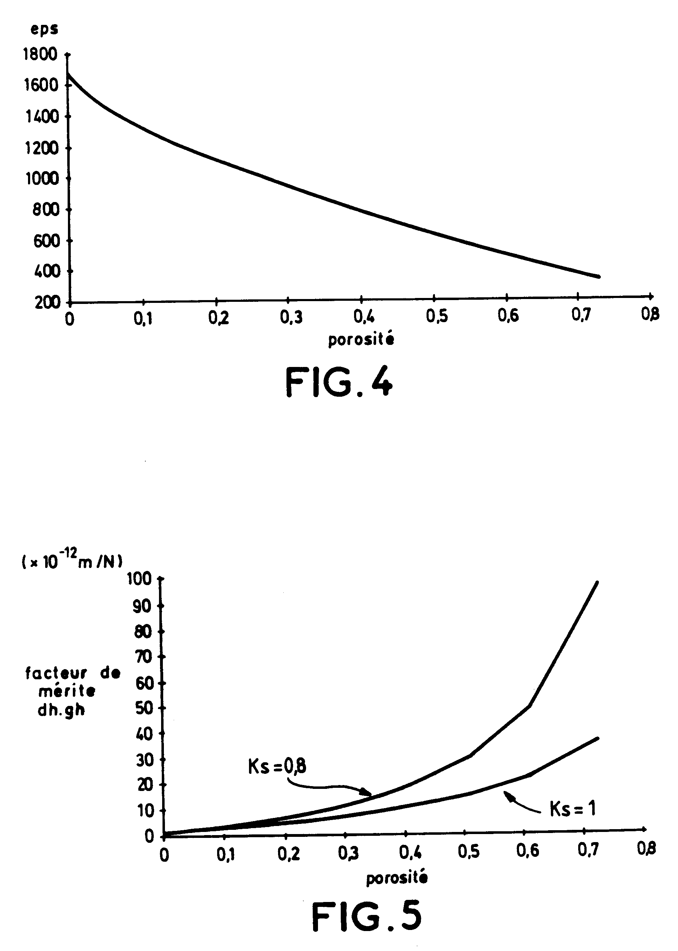

Malgré l'intérêt que représente le PZT réplique corail, il s'agit d'un matériau fragile, difficile à mettre en oeuvre et dont l'architecture des pores est figée, alors qu'un modèle tel que le modèle de Banno (Jpn.J of Applied Phys. 24 (1985), suppl. 24-2, 445-7) montre l'incidence de la forme des pores sur différents coefficients ($d_{31}$, $d_{33}$, $_{33}$). Les figures 2 à 5 illustrent les variations de ces coefficients avec la porosité et la forme des pores. Ce modèle montre qu'il est intéressant de réaliser des céramiques à forte porosité et d'induire des pores de forme allongée.

C'est pourquoi la présente invention propose un procédé de fabrication de céramique piézoélectrique dont la porosité est contrôlée et peut être très élevée contrairement au procédé de synthèse de céramiques poreuses par brûlage de liants durant le frittage de la poudre, qui ne permet d'atteindre des porosités que de 15 %. Le procédé selon l'invention comporte les étapes suivantes :

– synthèse d'un gel à forte porosité en présence de solvant et d'agents orientant la gélification
– synthèse de l'aérogel par séchage dans des conditions pour le solvant de pression et de température hypercritiques pour maintenir la taille et la forme des pores obtenus dans le gel
– obtention de la céramique par calcination de l'aérogel pour induire la structure désirée à haute température.

La présente invention a aussi pour objet la céramique piézoélectrique fabriquée selon le procédé de l'invention. Cette céramique poreuse est de préférence du titanate de baryum ou du titano zirconate de plomb. Les molécules orientant la gélification sont de préférence des molécules d'acétyl-acétone (acac) ou d'acide acétique.

La présente invention sera mieux comprise et d'autres avantages apparaîtront à la lecture de la description qui va suivre et des figures annexées parmi lesquelles :

– la figure 1 représente des structures de matériaux composites de connectivité variable ;
– la figure 2 montre l'évolution du coefficient de charge en fonction de la porosité selon le modèle de Banno. ($K_s$ = 1 pore cubique, $k_s$ = 0, 8 pore parallélépipèdique) ;
– la figure 3 montre l'évolution du coefficient $d_h$ en fonction de la porosité selon le modèle de Banno ;
– la figure 4 montre l'évolution le la permittivité en fonction de la la porosité selon le modèle de Banno ;
– la figure 5 montre l'évolution du facteur de mérite $d_h.g_h$ en fonction de la porosité selon le modèle de Banno.

On sait que la structure de gels obtenus à partir d'alcoxydes organiques est très poreuse. Cependant ces gels se rétractent fortement lors du séchage à la pression atmosphérique entraînant une forte diminution de la porosité. Pour éviter ce retrait la présente invention propose de sécher dans des conditions de température et de pression hypercritiques où l'équilibre liquide-vapeur n'existe plus. Par une détente adiabatique le fluide à éliminer passe des pores au volume libre situé au-dessus du gel sans changement d'état donc sans dilatation, les contraintes dues aux suppressions à l'intérieur du gel sont ainsi annulées. Les aérogels obtenus peuvent alors avoir les porosités atteignant 90 %. Par calcination à température modérée de cet aérogel, on obtient une céramique poreuse, de porosité contrôlée pouvant aller jusqu'à 70 %. La porosité est gouvernée lors de la synthèse du gel par la présence de molécules chélatantes qui bloquant certaines fonctions des précurseurs, orientent l'architecture du gel en empêchant la création de certaines liaisons.

On va donner un exemple de synthèse de PZT à forte porosité :

On synthétise un gel de PZT en mélangeant du plomb sous forme de carboxylate (acétate, 2-éthyl-hexanoate ... ), du titane et du zirconium sous forme d'alcoxyde (iso ou n.propoxyde ou butoxyde) dans un alcool comme le propanol 1. Après réaction dans un reflux, d'alcoxyde complexe est hydrolysé avec environ entre 1 et 10 moles d'eau par mole de plomb, par addition d'un mélange eau-propanol. Le gel obtenu est placé dans un autoclave possédant une vanne de détente. On monte la température à plus de 263,5°C (température critique du propanol) de façon à ce que la pression dépasse 51 atm (pression critique), le volume étant choisi pour répondre à cette condition, selon l'isotherme de Van der Waals. On détend alors dans un volume plus grand tout en restant dans l'état hypercritique et, au refroidissement, on récupère l'aérogel à 70 % de porosité et le solvant, séparés l'un de l'autre.

L'aérogel est alors cuit dans un four de façon à cristalliser la phase PZT sans la densifier pour préserver la même porosité, à une température comprise entre 300 et 500°C.

**Revendications**

1. Procédé d'obtention d'une céramique piézoélectrique à porosité contrôlée caractérisé en ce qu'il comprend les étapes suivantes :
   – synthèse d'un gel en présence d'un solvant
   – synthèse d'un l'aérogel par séchage du gel dans des conditions de pression et de température hypercritiques pour le solvant
   – obtention de la céramique par calcination de l'aérogel.

2. Procédé d'obtention d'une céramique piézoélectrique selon la revendication 1, caractérisé en ce que la forme des pores obtenus dans le gel est contrôlée en orientant la gélification avec des molécules chélatantes.

3. Procédé d'obtention d'une céramique piézoélectrique selon la revendication 2, caractérisé en ce que les molécules chélatantes sont des molécules d'acétyl-acétone ou d'acide acétique.

4. Procédé d'obtention d'une céramique piézoélectrique selon l'une des revendications 1 à 3 caractérisé en ce que la synthèse du gel est obtenue en mélangeant du plomb sous forme de carboxylate, du titane et du zirconium sous forme d'alcoxyde, dans un alcool.

5. Procédé d'obtention d'une céramique piézoélectrique selon l'une des revendications 1 à 3 caractérisé en ce que la synthèse du gel est obtenue en mélangeant du baryum sous forme carboxylate et du titane sous forme d'alcoxyde dans un alcool.

# FIG. 1

FIG.2

FIG.3

FIG.4

FIG.5

7

Office européen
des brevets

**RAPPORT DE RECHERCHE EUROPEENNE**

Numero de la demande

EP 91 40 2170

Page 1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| Y | GB-A-1 313 091 (ELECTICITY COUNCEL)<br>* revendications 1,15 *<br>--- | 1 | C04B38/00<br>C04B35/46<br>C04B35/48<br>H01L41/187 |
| Y | WO-A-8 808 360 (SIEMENS)<br>* page 2, ligne 19 - ligne 32 *<br>--- | 1 | |
| A | CHEMICAL ABSTRACTS, vol. 112, no. 2,<br>8 Janvier 1990, Columbus, Ohio, US;<br>abstract no. 11055,<br>SUMITOMO METAL MINING CO.: 'Porous lead<br>zirconate ceramics, and their manufacture.'<br>page 221 ;<br>* abrégé *<br>& JP-A-01 145 384 (SUMITOMO METAL MINING CO.) 7<br>Juin 1989<br>--- | 1,4 | |
| A | CHEMICAL ABSTRACTS, vol. 109, no. 18,<br>31 Octobre 1988, Columbus, Ohio, US;<br>abstract no. 161668H,<br>L. DEL OLMO ET AL.: 'Study and preparation of<br>ceramic particles as piezoelectric precursors of<br>modified lead titanate.'<br>page 839 ;<br>* abrégé *<br>& FERROELECTRICS.<br>vol. 81, 1988, LONDON GB<br>pages 269 - 272;<br>--- | 1,4 | DOMAINES TECHNIQUES RECHERCHES (Int. Cl.5 )<br><br>C04B<br>H01L |
| A | US-A-4 402 927 (G. VON DARDEL ET AL.)<br>* Résumé *<br>--- | 1 | |
| A | CHEMICAL ABSTRACTS, vol. 109, no. 26,<br>Décembre 1988, Columbus, Ohio, US;<br>abstract no. 235796X,<br>S. OKITA ET AL: 'Method for manufactering molded<br>ceramic precursors.'<br>page 305 ;<br>* abrégé *<br>& JP-A-63 166 777 (NIPPON STEEL CORP. ETC.) 9<br>Juillet 1988 | 1 | |

Le présent rapport a été établi pour toutes les revendications

| Lieu de la recherche | Date d'achèvement de la recherche | Examinateur |
|---|---|---|
| LA HAYE | 25 OCTOBRE 1991 | P.C.A. DAELEMAN |

**Office européen des brevets**

# RAPPORT DE RECHERCHE EUROPEENNE

Numero de la demande

EP 91 40 2170
Page 2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| | --- | | |
| A | FR-A-2 223 324 (CORNING GLASS)<br>* revendication 1 * | | |
| | ----- | | |

DOMAINES TECHNIQUES RECHERCHES (Int. Cl.5)

Le présent rapport a été établi pour toutes les revendications

| Lieu de la recherche | Date d'achèvement de la recherche | Examinateur |
|---|---|---|
| LA HAYE | 25 OCTOBRE 1991 | P.C.A. DAELEMAN |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
........................................................................................
& : membre de la même famille, document correspondant

EPO FORM 1503 03.82 (P0402)

9